# EUROPEAN PATENT SPECIFICATION

(11) **EP 3 048 779 B1**
(45) Date of publication and mention of the grant of the patent: **27.02.2019**
(21) Application number: 14845157.8
(22) Date of filing: 28.04.2014
(51) Int. Cl.: H04M 1/60, H04M 1/20, H03G 7/00

(54) **SOUND VOLUME ADJUSTING METHOD AND DEVICE**
LAUTSTÄRKEEINSTELLUNGSVERFAHREN UND -VORRICHTUNG
PROCÉDÉ ET DISPOSITIF DE RÉGLAGE DE VOLUME SONORE

(30) Priority: 17.09.2013 CN 201310426110
(43) Date of publication of application: 27.07.2016
(73) Proprietor: ZTE Corporation, Shenzhen, Guangdong 518057 (CN)
(72) Inventor: LIANG, Chao, Shenzhen Guangdong 518057 (CN); SUN, Tao, Shenzhen Guangdong 518057 (CN); XU, Dongyan, Shenzhen Guangdong 518057 (CN)
(74) Representative: Lavoix
(86) International application number: PCT/CN2014/076411
(87) International publication number: WO 2015/039441

(56) References cited:
- EP-A1- 2 202 881
- WO-A1-2008/076517
- WO-A2-01/39370
- CN-A- 102 318 325
- CN-A- 102 915 753
- CN-A- 103 152 668
- CN-A- 103 259 898

## Description

### TECHNICAL FIELD

The present disclosure relates to the field of application of terminals, and in particular to a playback loudness adjustment method and device for adjusting playback loudness when a terminal performs a playback.

### BACKGROUND

When a user listens to music in a loudspeaker mode on a terminal, for a same playback volume set on the terminal, the user perceives quite different loudspeaker playback loudness due to different external environments where the user is located, for example, on a street, in a vehicle, in an elevator, or at home; for the same volume, the user may feel that ring tone loudness is small when located in a broad space or a noisy environment, and the user may feel that the ring tone loudness is large when located in a narrow space or a silent environment; in this case, the user is required to adjust the playback loudness manually to obtain a better playback effect.

Accordingly, how to provide a method for adjusting playback loudness of a terminal without a manual operation by the user is a technical problem urgently to be solved by those skilled in the art.

The document EP 2202881 A1 discloses that a signal processing apparatus includes a first audio adjustment information generator generating a first audio adjustment information in accordance with an audio signal in a content item, a sound input unit, a sound output unit, an audio separator separating the audio signal from noise signals which are both output from the sound output unit and are detected by the sound input unit, a second audio adjustment information generator generating a second audio adjustment information in accordance with the noise signals separated by the audio separatos, and an audio adjustment unit adjusting a volume of the audio signal output in the sound output unit in accordance with the first and second audio adjustment information.

The document WO 2008/076517 A1 discloses that a radio device includes: a speaker, which outputs audio signals, a microphone that detects and receives audible sounds within the surroundings of the radio device; an audio volume/characteristic adjusting mechanism, which selectively increases and decreases the volume level or other audio characteristics of the audio signal outputted from the radio device based on a user input; and means for dynamically adjusting the audio volume and other audio characteristics of the audio signal based on a stored relational mapping, which links a user adjustment of the audio volume/characteristic to a specific audible sound previously detected within the environment by the microphone, such that future detection of the audible sound by the microphone triggers the dynamically adjusting of the audio volume and other audio characteristics.

The document CN 102915753 A discloses a method for intelligently controlling volume of an electronic device and an implementation device of the method. A microphone is arranged inside the electronic device. The method comprises the following steps: receiving an external voice picked up by the microphone; extracting content information from the external voice; judging if a voice matched with the content information of the external voice is stored in a pre-stored voice template library according to the content information of the external voice, and generating a first judgment result; and if the first judgment result is positive, adjusting the volume of the voice which is outputting or generating a warning voice, closing the voice which is outputting and outputting the warning voice; according to the method and the implementation device, the electronic device can intelligently control the voice according to the external voice.

The document WO 01/39370 A2 discloses a partitioned signal processing system and methods for controlling signals, especially audio signals, within a varying environment which may include a user interface, input signal preprocessing, one or more adaptive dynamic companders, power estimators, noise compensation, and output processing. The system and method may be implemented in either hardware or software or both.

### SUMMARY

In order to solve an existing technical problem, an embodiment of the present disclosure provides a playback loudness adjustment method and device. The invention is described by the contents of the independent claims.

An embodiment of the present disclosure provides a playback loudness adjustment method, and the method includes: a terminal acquires an environment sound signal and an internal sound signal, and acquires a playback loudness difference value according to the environment sound signal and the internal sound signal; and the terminal compares the playback loudness difference value with at least one adjustment threshold, and adjusts playback loudness according to a comparison result; wherein acquiring the playback loudness difference value according to the environment sound signal and the internal sound signal comprises: acquiring a loudness value of each sound signal of the environment sound signal, taking a sound signal having the largest loudness value as a main sound signal, and acquiring the playback loudness difference value according to the loudness value of the main sound signal and a loudness value of the internal sound signal.

In an embodiment, the step that the terminal acquires the playback loudness difference value according to the environment sound signal and the internal sound signal may include: a noise signal in the environment sound signal is filtered out, to obtain a playback echo signal; and the playback loudness difference value is acquired according to a loudness value of the playback echo signal and a loudness value of the internal sound signal; wherein the noise signal refers to all sound signals received by a microphone except the playback echo signal.

In an embodiment, the method may further include: before the noise signal in the environment sound signal is filtered out, the noise signal in the environment sound signal is filtered out, and the step that the noise signal in the environment sound signal is filtered out may specifically be: the noise signal determined in the environment sound signal is filtered out.

In an embodiment, the step that the noise signal is determined may include: a signal part of the environment sound signal relating to the internal sound signal is filtered out according to a correlation of sound signals, and the noise signal is obtained and output; herein the correlation of the sound signals includes a waveform correlation of the sound signals.

In an embodiment, the step that the terminal acquires the playback loudness difference value according to the environment sound signal and the internal sound signal may include: a loudness value of each sound signal of the environment sound signal is acquired, the sound signal having the largest loudness value is taken as a main sound signal, and the playback loudness difference value is acquired according to the loudness value of the main sound signal and a loudness value of the internal sound signal.

In an embodiment, when there is only one adjustment threshold, the step that the terminal adjusts the playback loudness according to the comparison result may include: the playback loudness is increased when the playback loudness difference value is larger than the adjustment threshold, and the playback loudness is reduced when the playback loudness difference value is smaller than the adjustment threshold; and when there are two or more adjustment thresholds, the step that the terminal adjusts the playback loudness according to the comparison result may include: the playback loudness is increased when the playback loudness difference value is larger than a maximum value of the adjustment thresholds, and the playback loudness is reduced when the playback loudness difference value is smaller than a minimum value of the adjustment thresholds, and the playback loudness is not adjusted when the playback loudness difference value is between the minimum value and the maximum value of the adjustment thresholds.

In an embodiment, the method may further include: after the playback loudness is adjusted, the adjustment threshold is adjusted according to a playback loudness difference value when the adjustment is performed and a modification threshold; specifically, when there is only one adjustment threshold, the step that the adjustment threshold is updated according to the playback loudness difference value when the adjustment is performed and the modification threshold may include: a sum of or a difference between the playback loudness difference value when the adjustment is performed and the modification threshold is taken as a new adjustment threshold; and when there are two or more adjustment thresholds, the step that the adjustment threshold is updated according to the playback loudness difference value when the adjustment is performed and the modification threshold may include: a sum of the playback loudness difference value when the adjustment is performed and the modification threshold is taken as the maximum value of a new adjustment threshold, and a difference between the playback loudness difference value when the adjustment is performed and the modification threshold is taken as the minimum value of the new adjustment threshold.

An embodiment of the present disclosure provides a playback loudness adjustment device, which includes a processing module and an adjusting module, wherein the processing module is configured to acquire an environment sound signal and an internal sound signal, and acquire a playback loudness difference value according to the environment sound signal and the internal sound signal; and the adjusting module is configured to compare the playback loudness difference value with at least one adjustment threshold, and adjust playback loudness according to a comparison result; wherein the processing module is further configured to acquire a loudness value of each sound signal of the environment sound signal, take a sound signal having the largest loudness value as a main sound signal, and acquire the playback loudness difference value according to the loudness value of the main sound signal and a loudness value of the internal sound signal.

In an embodiment, the processing module may include a filtering sub-module and a calculating sub-module, wherein
the filtering sub-module is configured to filter out a noise signal in the environment sound signal to obtain a playback echo signal; and
the calculating sub-module is configured to acquire the playback loudness difference value according to a loudness value of the playback echo signal and a loudness value of the internal sound signal.

In an embodiment, the processing module may further include a determining sub-module configured to determine the noise signal in the environment sound signal before the noise signal in the environment sound signal is filtered out; and
the filtering sub-module is configured to filter out the noise signal in the environment sound signal determined by the determining sub-module.

In an embodiment, the determining sub-module may be configured to filter out a signal part of the environment sound signal relating to the internal sound signal according to a correlation of sound signals, obtain and output the noise signal, wherein the correlation of the sound signals includes a waveform correlation of the sound signals.

In an embodiment, when there is only one adjustment threshold, the adjusting module may be configured to: increase the playback loudness when the playback loudness difference value is larger than the adjustment threshold, and reduce the playback loudness when the playback loudness difference value is smaller than the adjustment threshold; and
when there are two or more adjustment thresholds, the adjusting module may be configured to: increase the playback loudness when the playback loudness difference value is larger than the maximum value of the adjustment thresholds, and reduce the playback loudness when the playback loudness difference value is smaller than the minimum value of the adjustment thresholds, and not adjust the playback loudness when the playback loudness difference value is between the minimum value and the maximum value of the adjustment thresholds.

In an embodiment, the device may further include an updating module configured to, after the adjusting module adjusts the playback loudness, update the adjustment threshold according to the playback loudness difference value when the adjustment is performed and a modification threshold.

Advantageous effects of the embodiments of the present disclosure are as follows.

In a playback loudness adjustment method and device provided by embodiments of the present disclosure, a terminal collects an environment sound signal and an internal sound signal when performing a playback, and acquires playback loudness difference value according to the environment sound signal and the internal sound signal, namely a relative difference value between playback loudness perceived by a user and the terminal's internal loudness, and then adjusts playback loudness of the terminal according to the relation between the playback loudness difference and an adjustment threshold. The method and device solve a problem in the related art that the user is required to adjust a playback volume of a terminal manually in different environments, so that the terminal can automatically detect an environment in which it is located, and can implement automatic adjustment of the playback volume according to the environment in which it is located, thereby improving user experience.

### BRIEF DESCRIPTION OF THE DRAWINGS

Fig. 1 is a schematic diagram of a playback loudness adjustment method provided by a first embodiment of the present disclosure;
Fig. 2 is a schematic diagram of a playback loudness adjustment method provided by a second embodiment of the present disclosure;
Fig. 3 is a schematic diagram of a playback loudness adjustment device provided by a third embodiment of the present disclosure;
Fig. 4 is a schematic diagram of a circuit structure of a playback loudness adjustment device provided by a fourth embodiment of the present disclosure; and
Fig. 5 is a schematic diagram of a playback loudness adjustment method provided by a fifth embodiment of the present disclosure.

### DETAILED DESCRIPTION

The present disclosure is further interpreted and explained now based on embodiments with reference to accompanying drawings.

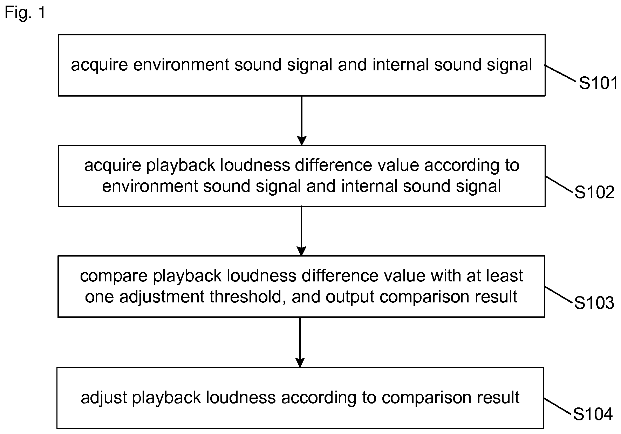

Fig. 1 is a schematic diagram of a playback loudness adjustment method provided by a first embodiment of the present disclosure. It can be known from Fig. 1 that in the present embodiment, a playback loudness adjustment method provided by the present disclosure includes the following steps:
S101: a terminal acquires an environment sound signal and an internal sound signal.

The terminal in embodiments of the present disclosure refers to an apparatus which can perform a playback and receive an outside sound signal, and the terminal includes but is not limited to a mobile phone, a computer, a handheld computer and the like, and preferably may be a mobile terminal such as a mobile phone. The environment sound signal in embodiments of the present disclosure refers to all sound signals in an environment in which a terminal is located; in embodiments of the present disclosure, the environment sound signal can be divided into two parts according to effects thereof: a noise signal and a playback echo signal, herein the playback echo signal refers to an echo signal of a sound playbacked by the terminal through an sound amplifying device such as a loudspeaker and the like, the echo signal being collected by the terminal through a microphone, and the playback echo signal mainly includes a sound signal emitted from a loudspeaker which is received by a microphone after being emitted, or being reflected by an external environment; the noise signal refers to all sound signals received by the microphone except the playback echo signal. The internal sound signal in embodiments of the present disclosure refers to a sound signal which the terminal needs to amplify through the loudspeaker, namely the sound signal before experiencing power amplification. The playbacked sound in embodiments of the present disclosure includes but is not limited to a sound output by the loudspeaker when the terminal plays the music, or the terminal performs an operation such as telephone communication, video or audio communication, or etc.

S102: a playback loudness difference value is acquired according to the environment sound signal and the internal sound signal.

The playback loudness difference value in the application mainly refers to a difference between a loudness value of the internal sound signal inside the terminal and a loudness value of the playback echo signal.

When there is no noise or the noise can be ignored in an external environment in which the terminal is located, the loudness value of the environment sound signal may be directly taken as the loudness value of the playback echo signal.

When the noise in the external environment in which the terminal is located cannot be ignored, there is a need to filter out the noise signal to obtain a pure playback echo signal, so as to perform calculation of the playback loudness difference value. Then, at this time, the acquiring a playback loudness difference value according to the environment sound signal and the internal sound signal includes: filtering out a noise signal in the environment sound signal, to obtain a playback echo signal; and acquiring the playback loudness difference value according to a loudness value of the playback echo signal and a loudness value of the internal sound signal.

Preferably, the method further includes: before filtering out the noise signal in the environment sound signal, determining the noise signal in the environment sound signal, and filtering out the noise signal in the environment sound signal may specifically be: filtering out the noise signal determined in the environment sound signal.

Preferably, the determining the noise signal includes: filtering out a signal part of the environment sound signal relating to the internal sound signal according to a correlation of sound signals, and the noise signal is obtained and output; herein the correlation of the sound signals includes a waveform correlation of the sound signals, such as an amplitude, a frequency and a phase of the sound signal and the like
The playback loudness difference value in the application may also be a difference between the loudness value of the internal sound signal inside the terminal and a loudness value of a main sound signal in the environment sound signal; specifically, a loudness value of each sound signal of the environment sound signal is acquired, a sound signal having the largest loudness value is taken as the main sound signal, and the playback loudness difference value is acquired according to the loudness value of the main sound signal and the loudness value of the internal sound signal.

S103: the terminal compares the playback loudness difference value with at least one adjustment threshold, and outputs a comparison result.

The adjustment threshold in the application mainly functions as a judgment condition needed by the terminal to perform playback loudness adjustment, and may be a determined value. Then, at this time, the comparison result only has two cases, in which the result includes being larger than and smaller than the adjustment threshold respectively. This adjustment way is preferable, and can ensure that the playback loudness difference value is a constant value. The playback loudness difference value is directly related to a usage perception of the user. When the playback loudness difference value is kept unchanged, equivalently a playback effect of the terminal heard by the user of the terminal is stably unchanged, and the effect is optimal. However, in an actual application, the environment in which the terminal is located may change frequently, and this adjustment way may result in that the terminal is required to adjust the playback loudness in real time, causing waste of electric power.

Accordingly, in other embodiments, the adjustment threshold may be two or more values, or a value range. At this time, the comparison result will have three cases in which the result includes being larger than the maximum value of the adjustment threshold, smaller than the minimum value of the adjustment threshold, and between the minimum value and the maximum value of the adjustment threshold. This embodiment may have a certain compatibility. For example, when the comparison result is between the minimum value and the maximum value of the adjustment threshold, the playback loudness of the terminal is not adjusted, which may reduce the waste of the electronic power to a certain extent.

S104: the terminal adjusts the playback loudness according to the comparison result.

When the number of the thresholds is different, there are different adjustment schemes, which are now explained respectively:
When there is only one adjustment threshold, the adjusting the playback loudness according to the comparison result includes: increasing the playback loudness when the playback loudness difference value is larger than the adjustment threshold, and reducing the playback loudness when the playback loudness difference value is smaller than the adjustment threshold.

When there are two or more adjustment thresholds, the adjusting the playback loudness according to the comparison result includes: increasing the playback loudness when the playback loudness difference value is larger than the maximum value of the adjustment thresholds, and reducing the playback loudness when the playback loudness difference value is smaller than the minimum value of the adjustment thresholds, and not adjusting the playback loudness when the playback loudness difference value is between the minimum value and the maximum value of the adjustment thresholds.

It can be predicted that in another embodiment of the application, determination of the playback loudness adjustment threshold can be implemented in a way of setting more than three adjustment thresholds or more than two adjustment threshold ranges. For example, with respect to the way of setting more than two adjustment threshold ranges, when the comparison result is that the playback loudness difference value is in (1, 2), a playback loudness value is reduced by 4 DB, and when the comparison result is that the playback loudness difference value is in (2, 3), the playback loudness value is reduced by 2 DB, and when the comparison result is that the playback loudness difference value is in (3, 4), the adjustment is not performed, and when the comparison result is that the playback loudness difference value is in (4, 5), the playback loudness value is increased by 2DB, and so on, which will not be repeated.

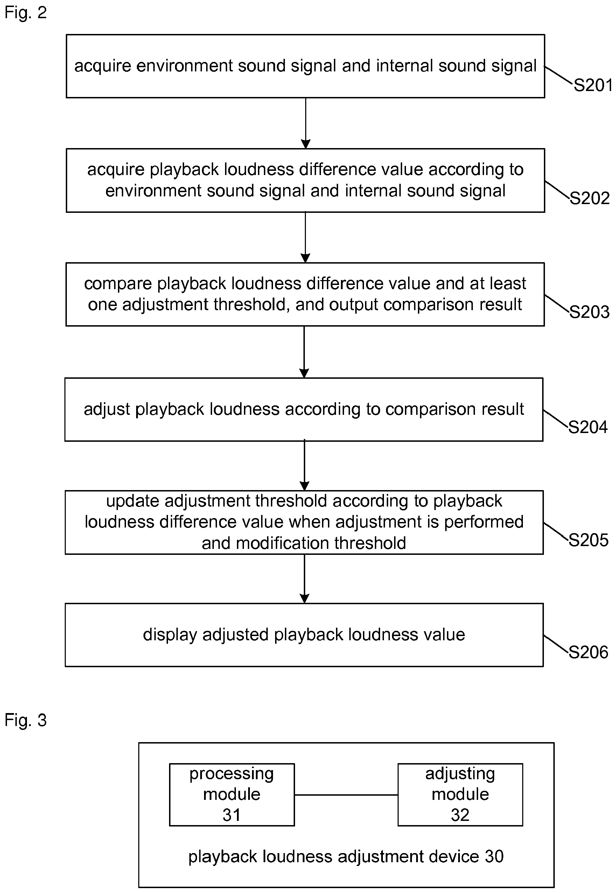

Fig. 2 is a schematic diagram of a playback loudness adjustment method provided by a second embodiment of the present disclosure. It can be known from Fig. 2 that in this embodiment, the playback loudness adjustment method includes the following steps.

S201-S204: a terminal acquires an environment sound signal and an internal sound signal, and acquires a playback loudness difference value according to the environment sound signal and the internal sound signal; and the terminal compares the playback loudness difference value with at least one adjustment threshold, and adjusts the playback loudness according to a comparison result; the four steps are the same as those in Fig. 1, and will not be repeated.

S205: the adjustment threshold is updated according to a playback loudness difference value when the adjustment is performed and a modification threshold.

A purpose of this step is to make each adjustment of the playback loudness performed by the terminal to be performed based on a previous adjustment. In this way, when the terminal moves from an environment to another environment, a fault of the loudness adjustment may not emerge. Specifically, when the number of the adjustment thresholds is different, there are different updating schemes, which are respectively explained:
When there is only one adjustment threshold, the updating the adjustment threshold according to the playback loudness difference value when the adjustment is performed and the modification threshold specifically includes: taking a sum of or a difference between the playback loudness difference value when the adjustment is performed and the modification threshold as a new adjustment threshold, or directly taking the playback loudness difference value when the adjustment is performed as a new modification threshold.

When there are two or more adjustment thresholds, the updating the adjustment threshold according to the playback loudness difference value when the adjustment is performed and the modification threshold specifically includes: taking a sum of the playback loudness difference value when the adjustment is performed and the modification threshold as the maximum value of a new adjustment threshold, and taking a difference between the playback loudness difference value when the adjustment is performed and the modification threshold as the minimum value of the new adjustment threshold.

S206: the adjusted playback loudness value is displayed.

A purpose of performing this step is to enable a terminal user to know the adjusted terminal playback loudness value, to avoid a problem that upon a next usage of the terminal, the feeling of the user is bad due to a too large or small playback loudness value.

It can be predicted that, a sequence of the steps S204 and S206 in the embodiment shown in Fig. 2 may be inversed.

Fig. 3 is a schematic diagram of a playback loudness adjustment device provided by a third embodiment of the present disclosure. It can be known from Fig. 3 that in this embodiment, a playback loudness adjustment device 30 includes a processing module 31 and an adjusting module 32, wherein
the processing module 31 is configured to acquire an environment sound signal and an internal sound signal, and acquire a playback loudness difference value according to the environment sound signal and the internal sound signal; and
the adjusting module 32 is configured to compare the playback loudness difference value with at least one adjustment threshold, and adjust playback loudness according to a comparison result.

Preferably, in another embodiment, the processing module 31 in the embodiment shown in Fig. 3 includes a filtering sub-module and a calculating sub-module, wherein
the filtering sub-module is configured to filter out a noise signal in the environment sound signal to obtain to obtain a playback echo signal; and the calculating sub-module is configured to acquire the playback loudness difference value according to a loudness value of the playback echo signal and a loudness value of the internal sound signal.

Preferably, in another embodiment, the processing module 31 in the embodiment shown in Fig. 3 further includes a determining sub-module configured to determine the noise signal in the environment sound signal before f the noise signal in the environment sound signal is filtered out; and the filtering sub-module is configured to filter out the noise signal in the environment sound signal determined by the determining sub-module.

Preferably, in another embodiment, the determining sub-module in the above embodiment is configured to filter out a signal part of the environment sound signal relating to the internal sound signal according to a correlation of sound signals, obtain and output the noise signal, herein the correlation of the sound signals includes a waveform correlation of the sound signals.

Preferably, in another embodiment, when there is only one adjustment threshold, the adjusting module 32 in the embodiment shown in Fig. 3 is configured to: increase the playback loudness when the playback loudness difference value is larger than the adjustment threshold, and reduce the playback loudness when the playback loudness difference value is smaller than the adjustment threshold; and when there are two or more adjustment thresholds, the adjusting module 32 in the embodiment shown in Fig. 3 is configured to: increase the playback loudness when the playback loudness difference value is larger than the maximum value of the adjustment thresholds, and reduce the playback loudness when the playback loudness difference value is smaller than the minimum value of the adjustment thresholds, and not adjust the playback loudness when the playback loudness difference value is between the minimum value and the maximum value of the adjustment thresholds.

Preferably, in another embodiment, the playback loudness adjustment device 30 in the embodiment shown in Fig. 3 further includes an updating module configured to update the adjustment threshold according to the playback loudness difference value when the adjustment is performed and a modification threshold, after the adjusting module adjusts the playback loudness.

Preferably, in another embodiment, the playback loudness adjustment device 30 in the embodiment shown in Fig. 3 further includes a display module, configured to display an adjusted loudness value of the playback loudness after the adjusting module adjusts the playback loudness.

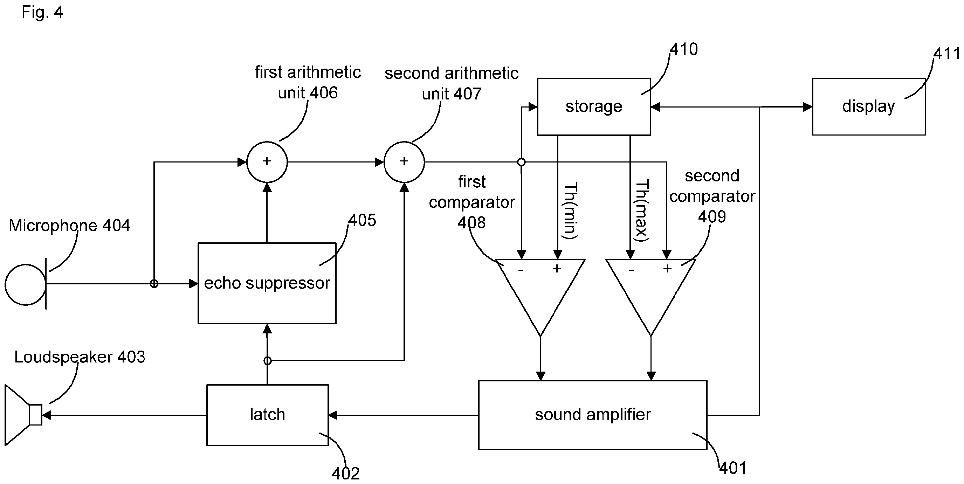

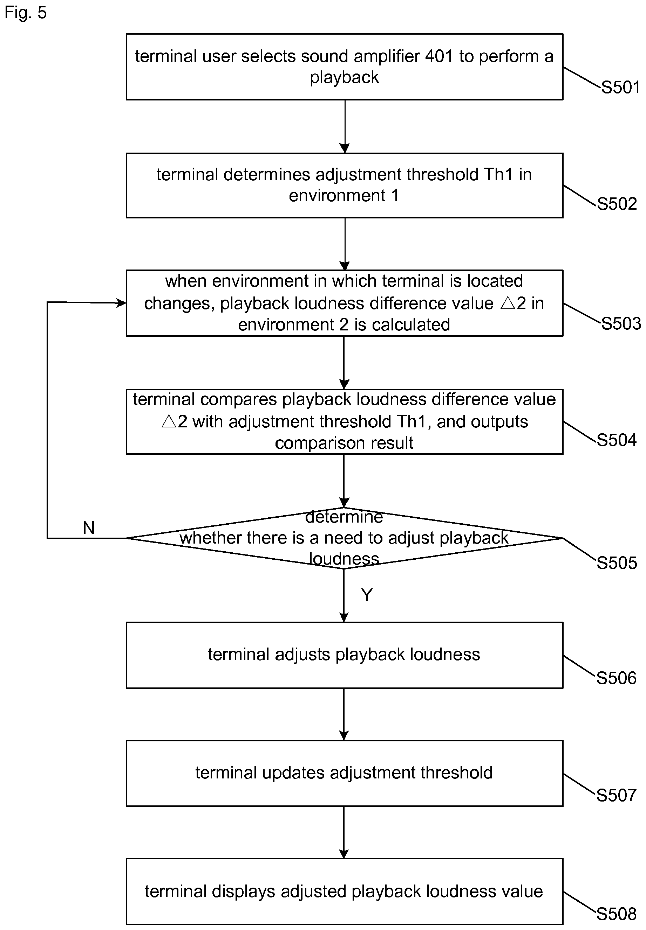

Fig. 4 is a schematic diagram of a circuit structure of a playback loudness adjustment device provided by a fourth embodiment of the present disclosure; and Fig. 5 is a schematic diagram of a playback loudness adjustment method provided by a fifth embodiment of the present disclosure. The present disclosure is further interpreted and illustrated now taken in conjunction with a particular application example, and Figs. 4 and 5.

It can be known from Fig. 4 that the playback loudness adjustment device in an application example of the present disclosure is composed of the following circuit elements: a sound amplifier 401, a latch 402, a loudspeaker 403, a microphone 404, an echo suppressor 405, a first and second arithmetic unit 406 and 407, a first and second comparator 408 and 409, a storage 410, and a display 411. A connection relationship between individual circuit elements is referred in Fig. 4. A relationship between Fig. 4 and the playback loudness adjustment device shown in Fig. 3 is: the latch 402, the microphone 404, the echo suppressor 405, and the first and second arithmetic unit 406 and 407 are equivalent to the processing module 31 in Fig. 3, while the sound amplifier 401 and the first and second comparator 408 and 409 are equivalent to the adjusting module 32 in Fig. 3. The present application is further explained now taken in conjunction with Fig. 5, and it can be known form Fig. 5 that the playback loudness adjustment provided in this application example includes the following steps.

S501: a terminal user selects a sound amplifier 401 to perform a playback of a ring tone signal A, and sets playback loudness thereof as a.

S502: a terminal determines an adjustment threshold Th1 in an environment 1;
this step specifically includes:
the latch 402 latches the ring tone signal A, and playbacks a ring tone signal Y through the loudspeaker 403;
the microphone 404 collects an environment sound signal Z1 of the environment 1, and the environment sound signal Z1 includes a noise signal in the environment, and a playback echo signal R1 (A) of the ring tone signal A in the environment 1; and the environment sound signal Z1 is transmitted to the echo suppressor 405 and the first arithmetic unit 406;
the echo suppressor 405 filters out the playback echo signal R1(A) in the environment sound signal Z1 related to the ring tone signal A according to a waveform correlation to obtain a noise signal N1, and transmits the noise signal N1 to the first arithmetic unit 406;
the first arithmetic unit 406 subtracts the noise signal N1 from the environment sound signal Z1 to obtain the playback echo signal R1(A), and outputs it to the second arithmetic unit 407;
the second arithmetic unit subtracts a loudness value a1' of the playback echo signal R1(A) from a loudness value a of the ring tone signal A to obtain a playback loudness difference value Δ1 (Δ1=a-a1') in the environment 1, and outputs it to the storage 410;
the storage 410 determines and stores an adjustment threshold Th1 according to Δ1 and a modification threshold M, and in this embodiment, two thresholds are set, namely Th1 (min)=Δ1-M and Th1 (max)=Δ1+M.

S503: when the environment in which the terminal located changes, the playback difference value Δ2 in an environment 2 is calculated in a way as follows.

The microphone 404 collects an environment sound signal Z2 in an environment 2, and transmits the environment sound signal Z2 to the echo suppressor 405 and the first arithmetic unit 406, wherein the environment sound signal Z2 includes a noise signal N2 in the environment 2 and a playback echo signal R2 (A) of the ring tone A in the environment 2;
the echo suppressor 405 filters out the playback echo signal R2 (A) in the environment sound signal Z2 related to the ring tone signal A according to the waveform correlation of the sound signal, to obtain a noise signal N2 and transmit it to the first arithmetic unit 406;
the first arithmetic unit 406 subtracts the noise signal N2 from the environment sound signal Z2 to obtain the playback echo signal R2 (A), and outputs it to the second arithmetic unit 407;
the second arithmetic unit 407 subtracts a loudness value a2' of the playback echo signal R2 (A) from a loudness value a of the ring tone signal A to obtain the playback loudness difference value Δ2 (Δ2=a-a2') in the environment 2, and outputs it to the first comparator 408 and the second comparator 409;
S504: the terminal compares the playback loudness difference value Δ2 with the adjustment threshold Th1, and outputs a comparison result;
the comparison result generated by the first comparator 408 and the second comparator 409 includes there results, specifically, which are: a comparison result 1: Δ 2 < Th1 (min); a comparison result 2 Th1 (min) ≤ Δ2 ≤ Th1 (max); and a comparison result 3: Δ2 > Th1 (max); the comparison results are transmitted to the sound amplifier 401.

S505: the terminal determines whether there is a need to perform loudness adjustment according to the comparison result;
specifically, this step is: the sound amplifier 401 determines whether there is a need to perform loudness adjustment on the ring tone signal and the loudness value according to the received comparison result; when the received comparison result is comparison result 1 or 3, a judgment result is that there is a need to perform adjustment and step S506 is executed; and when the received comparison result is the comparison result 2, the judgment result is that there is no need to perform the adjustment, and step S503 is returned and executed.

S506: the terminal adjusts the playback loudness;
specifically, this step is: the sound amplifier 401 adjusts the loudness value a of the ring tone signal A to a loudness value b;

S507: the terminal updates the adjustment threshold;
specifically, this step is: the storage 410 updates the adjustment threshold Th1 into the adjustment threshold Th2, which is specifically Th2 (min) =Δ2-M and Th2 (max) =Δ2+M

S508: the terminal displays the adjusted playback loudness value.

Specifically, this step is: the display 411 displays the adjusted loudness value b for the user.

An embodiment of the present disclosure also provides a computer-readable storage medium having stored therein a group of instructions used to execute the playback loudness adjustment method described in the embodiments of the present disclosure.

It can be known from the above that there are at least the following advantageous effects after implementation of the embodiments of the present disclosure:
A terminal collects an environment sound signal and an internal sound signal when amplifying a sound, and acquires a playback loudness difference value according to the environment sound signal and the internal sound signal, namely a relative difference value between playback loudness perceived by a user and terminal's internal loudness, and then adjusts playback loudness of a terminal according to the relation between the playback loudness difference and an adjustment threshold. The method and device solve a problem in the related art that the user is required to adjust a playback volume of a terminal manually in different environments, so that the terminal can automatically detect an environment in which the terminal is located, and can implement automatic adjustment of the playback volume according to the environment in which it is located, thereby improving user experience.

It should be known by these skilled in the art that, the embodiments of the present disclosure can be provided as a method, system or computer program product. Therefore, the present disclosure can employ forms such as a hardware embodiment, a software embodiment, or an embodiment combining software and hardware aspects. Also, the present disclosure can employ a form of a computer program produced embodied on one or more computer usable storage medium (including but not limit to a magnetic storage, an optical storage, and the like) containing therein a computer usable code.

The present disclosure is described with reference to a method, an apparatus (system), and a flowchart and/or a block diagram of a computer program product. It should be understood that each process and/or block in the flowchart and/or the block diagram, and a combination of the process and/or in the flowchart and/or the block diagram can be implemented by a computer program instruction. These computer program instructions may be provided to a computer, a specific computer, an embodied processor, or other programmable data processing apparatus to generate a machine, so as to generate a device for implementing a function designated in one or more processes of the flowchart and/or one or more blocks of the block diagrams through the instruction executed by a processor of a computer and the other programmable data processing apparatus.

These computer program instructions may also be stored in a computer readable storage which can instruct the computer or the other programmable data processing apparatus to operate in a certain way, so that the instructions in the instruction stored in this computer readable storage generate a manufacture including an instruction device, which implements the function designated in one or more processes of the flowchart and/or one or more blocks of the block diagrams.

These computer program instructions can also be loaded on the computer or the other programmable data processing device, so as to execute a serial of operation steps on the computer or the other programmable data processing apparatus to generate processing implemented by the computer, so that the instructions executed on the computer or the other programmable data processing apparatus provide a step for implementing the function designated in one or more processes of the flowchart and/or one or more blocks of the block diagrams.

The above is only a particular embodiment of the present disclosure, and is not limitation of the present disclosure in any form. Any simply modification, equivalent variation, or modification of the above embodiments made depending on the technical essence of the present disclosure still belongs to the protection scope of the technical scheme of the present disclosure.

## Claims

1. A playback loudness adjustment method, comprising:
acquiring (S101), by a terminal, an environment sound signal and an internal sound signal, and acquiring (S102) a playback loudness difference value according to the environment sound signal and the internal sound signal; and
comparing (S103), by the terminal, the playback loudness difference value with at least one adjustment threshold, and adjusting (S104) playback loudness according to a comparison result;
wherein acquiring the playback loudness difference value according to the environment sound signal and the internal sound signal comprises: acquiring a loudness value of each sound signal of the environment sound signal, taking the sound signal having the largest loudness value as a main sound signal, and acquiring the playback loudness difference value according to the loudness value of the main sound signal and a loudness value of the internal sound signal.

2. The playback loudness adjustment method according to claim 1, wherein acquiring the playback loudness difference value according to the environment sound signal and the internal sound signal comprises: filtering out a noise signal in the environment sound signal, to obtain a playback echo signal; and acquiring the playback loudness difference value according to a loudness value of the playback echo signal and a loudness value of the internal sound signal; wherein the noise signal refers to all sound signals received by a microphone except the playback echo signal.

3. The playback loudness adjustment method according to claim 2, further comprising: before filtering out the noise signal in the environment sound signal, a step of determining the noise signal in the environment sound signal,
wherein filtering out the noise signal in the environment sound signal comprises: filtering out the noise signal determined in the environment sound signal.

4. The playback loudness adjustment method according to claim 3, wherein the step of determining the noise signal comprises: filtering out a signal part of the environment sound signal relating to the internal sound signal according to a correlation of sound signals, obtaining and outputting the noise signal, wherein the correlation of the sound signals comprises a waveform correlation of the sound signals.

5. The playback loudness adjustment method according to any one of claims 1-4, wherein
when there is only one adjustment threshold, adjusting the playback loudness according to the comparison result comprises: increasing the playback loudness when the playback loudness difference value is larger than the adjustment threshold, and reducing the playback loudness when the playback loudness difference value is smaller than the adjustment threshold; and
when there are two or more adjustment thresholds, adjusting the playback loudness according to the comparison result comprises: increasing the playback loudness when the playback loudness difference value is larger than a maximum value of the adjustment thresholds, and reducing the playback loudness when the playback loudness difference value is smaller than a minimum value of the adjustment thresholds, and not adjusting the playback loudness when the playback loudness difference value is between the minimum value and the maximum value of the adjustment thresholds.

6. The playback loudness adjustment method according to any one of claims 1-4, further comprising: after adjusting the playback loudness, updating the adjustment threshold according to a playback loudness difference value when the adjustment is performed and a modification threshold.

7. The playback loudness adjustment method according to claim 6, wherein
when there is only one adjustment threshold, updating the adjustment threshold according to the playback loudness difference value when the adjustment is performed and the modification threshold comprises: taking a sum of or a difference between the playback loudness difference value when the adjustment is performed and the modification threshold as a new adjustment threshold; and
when there are two or more adjustment thresholds, updating the adjustment threshold according to the playback loudness difference value when the adjustment is performed and the modification threshold comprises: taking a sum of the playback loudness difference value when the adjustment is performed and the modification threshold as the maximum value of a new adjustment threshold, and taking a difference between the playback loudness difference value when the adjustment is performed and the modification threshold as the minimum value of the new adjustment threshold.

8. A playback loudness adjustment device (30), comprising a processing module (31) and an adjusting module (32), wherein
the processing module (31) is configured to acquire an environment sound signal and an internal sound signal, and acquire a playback loudness difference value according to the environment sound signal and the internal sound signal; and
the adjusting module (32) is configured to compare the playback loudness difference value with at least one adjustment threshold, and adjust playback loudness according to a comparison result;
wherein the processing module (31) is further configured to acquire a loudness value of each sound signal of the environment sound signal, take the sound signal having the largest loudness value as a main sound signal, and acquire the playback loudness difference value according to the loudness value of the main sound signal and a loudness value of the internal sound signal.

9. The playback loudness adjustment device (30) according to claim 8, wherein the processing module (31) comprises a filtering sub-module and a calculating sub-module, wherein
the filtering sub-module is configured to filter out a noise signal in the environment sound signal to obtain a playback echo signal; and
the calculating sub-module is configured to acquire the playback loudness difference value according to a loudness value of the playback echo signal and a loudness value of the internal sound signal.

10. The playback loudness adjustment device (30) according to claim 9, wherein the processing module (31) further comprises a determining sub-module configured to determine the noise signal in the environment sound signal before the noise signal in the environment sound signal is filtered out; and
the filtering sub-module is configured to filter out the noise signal in the environment sound signal determined by the determining sub-module.

11. The playback loudness adjustment device (30) according to claim 10, wherein the determining sub-module is configured to filter out a signal part of the environment sound signal relating to the internal sound signal according to a correlation of sound signals, obtain and output the noise signal, wherein the correlation of the sound signals comprises a waveform correlation of the sound signals.

12. The playback loudness adjustment device (30) according to any one of claims 8-11, wherein
when there is only one adjustment threshold, the adjusting module (32) is configured to: increase the playback loudness when the playback loudness difference value is larger than the adjustment threshold, and reduce the playback loudness when the playback loudness difference value is smaller than the adjustment threshold; and
when there are two or more adjustment thresholds, the adjusting module (32) is configured to: increase the playback loudness when the playback loudness difference value is larger than a maximum value of the adjustment thresholds, and reduce the playback loudness when the playback loudness difference value is smaller than a minimum value of the adjustment thresholds, and not adjust the playback loudness when the playback loudness difference value is between the minimum value and the maximum value of the adjustment thresholds.

13. The playback loudness adjustment device (30) according to any one of claims 8-11, further comprising: an updating module configured to, after the adjusting module (32) adjusts the playback loudness, update the adjustment threshold according to a playback loudness difference value when the adjustment is performed and a modification threshold.

14. A computer-readable storage medium having stored therein a group of instructions configured to execute the playback loudness adjustment method according to any one of claims 1-7.

## Patentansprüche

1. Abspiellautstärke-Einstellungsverfahren, umfassend:
Erfassen (S101) eines Umgebungstonsignals und eines internen Tonsignals durch ein Endgerät und Erfassen (S102) eines Abspiellautstärke-Differenzwertes gemäß dem Umgebungstonsignal und dem internen Tonsignal und
Vergleichen (S103) des Abspiellautstärke-Differenzwertes mit mindestens einem Einstellungsgrenzwert und Einstellen (S104) der Abspiellautstärke gemäß einem Vergleichsergebnis durch das Endgerät,
wobei das Erfassen des Abspiellautstärke-Differenzwertes gemäß dem Umgebungstonsignal und dem internen Tonsignal Folgendes umfasst: Erfassen eines Lautstärkewertes jedes Tonsignals des Umgebungstonsignals, Festlegen des Tonsignals mit dem größten Lautstärkewert als ein Haupttonsignal und Erfassen des Abspiellautstärke-Differenzwertes gemäß dem Lautstärkewert des Haupttonsignals und einem Lautstärkewert des internen Tonsignals.

2. Abspiellautstärke-Einstellungsverfahren nach Anspruch 1, wobei das Erfassen des Abspiellautstärke-Differenzwertes gemäß dem Umgebungstonsignal und dem internen Tonsignal Folgendes umfasst: Herausfiltern eines Rauschsignals in dem Umgebungstonsignal, um ein Abspielechosignal zu erhalten, und Erfassen des Abspiellautstärke-Differenzwertes gemäß einem Lautstärkewert des Abspielechosignals und einem Lautstärkewert des internen Tonsignals, wobei das Rauschsignal alle Tonsignale bezeichnet, die von einem Mikrofon empfangen werden, mit Ausnahme des Abspielechosignals.

3. Abspiellautstärke-Einstellungsverfahren nach Anspruch 2, ferner Folgendes umfassend: vor dem Herausfiltern des Rauschsignals in dem Umgebungstonsignal einen Schritt des Bestimmens des Rauschsignals in dem Umgebungstonsignal,
wobei das Herausfiltern des Rauschsignals in dem Umgebungstonsignal Folgendes umfasst: Herausfiltern des Rauschsignals, das in dem Umgebungstonsignal bestimmt wurde.

4. Abspiellautstärke-Einstellungsverfahren nach Anspruch 3, wobei der Schritt des Bestimmens des Rauschsignals Folgendes umfasst: Herausfiltern eines Signalteils des Umgebungstonsignals, der sich auf das interne Tonsignal bezieht, gemäß einer Korrelation der Tonsignale, Erhalten und Ausgeben des Rauschsignals, wobei die Korrelation der Tonsignale eine Wellenformkorrelation der Tonsignale umfasst.

5. Abspiellautstärke-Einstellungsverfahren nach einem der Ansprüche 1 bis 4, wobei,
wenn es nur einen Einstellungsgrenzwert gibt, das Einstellen der Abspiellautstärke gemäß dem Vergleichsergebnis Folgendes umfasst: Erhöhen der Abspiellautstärke, wenn der Abspiellautstärke-Differenzwert größer als der Einstellungsgrenzwert ist, und Verringern der Abspiellautstärke, wenn der Abspiellautstärke-Differenzwert kleiner als der Einstellungsgrenzwert ist, und
wenn es zwei oder mehr Einstellungsgrenzwerte gibt, das Einstellen der Abspiellautstärke gemäß dem Vergleichsergebnis Folgendes umfasst: Erhöhen der Abspiellautstärke, wenn der Abspiellautstärke-Differenzwert größer als ein Maximalwert der Einstellungsgrenzwerte ist, Verringern der Abspiellautstärke, wenn der Abspiellautstärke-Differenzwert kleiner als ein Minimalwert der Einstellungsgrenzwerte ist, und kein Einstellen der Abspiellautstärke, wenn der Abspiellautstärke-Differenzwert zwischen dem Minimalwert und dem Maximalwert der Einstellungsgrenzwerte liegt.

6. Abspiellautstärke-Einstellungsverfahren nach einem der Ansprüche 1 bis 4, ferner Folgendes umfassend: nach dem Einstellen der Abspiellautstärke Aktualisieren des Einstellungsgrenzwertes gemäß einem Abspiellautstärke-Differenzwert, wenn die Einstellung durchgeführt wird, und einem Modifikationsgrenzwert.

7. Abspiellautstärke-Einstellungsverfahren nach Anspruch 6, wobei
wenn es nur einen Einstellungsgrenzwert gibt, das Aktualisieren des Einstellungsgrenzwertes gemäß dem Abspiellautstärke-Differenzwert, wenn die Einstellung durchgeführt wird, und dem Modifikationsgrenzwert Folgendes umfasst: Festlegen einer Summe aus oder einer Differenz zwischen dem Abspiellautstärke-Differenzwert, wenn die Einstellung durchgeführt wird, und dem Modifikationsgrenzwert als einen neuen Einstellungsgrenzwert, und
wenn es zwei oder mehr Einstellungsgrenzwerte gibt, das Aktualisieren des Einstellungsgrenzwertes gemäß dem Abspiellautstärke-Differenzwert, wenn die Einstellung durchgeführt wird, und dem Modifikationsgrenzwert Folgendes umfasst: Festlegen einer Summe aus dem Abspiellautstärke-Differenzwert, wenn die Einstellung durchgeführt wird, und dem Modifikationsgrenzwert als den Maximalwert eines neuen Einstellungsgrenzwertes und Festlegen einer Differenz zwischen dem Abspiellautstärke-Differenzwert, wenn die Einstellung durchgeführt wird, und dem Modifikationsgrenzwert als den Minimalwert des neuen Einstellungsgrenzwertes.

8. Abspiellautstärke-Einstellungsvorrichtung (30), umfassend ein Verarbeitungsmodul (31) und ein Einstellungsmodul (32), wobei
das Verarbeitungsmodul (31) zum Erfassen eines Umgebungstonsignals und eines internen Tonsignals und zum Erfassen eines Abspiellautstärke-Differenzwertes gemäß dem Umgebungstonsignal und dem internen Tonsignal konfiguriert ist, und
das Einstellungsmodul (32) zum Vergleichen des Abspiellautstärke-Differenzwertes mit mindestens einem Einstellungsgrenzwert und zum Einstellen der Abspiellautstärke gemäß einem Vergleichsergebnis konfiguriert ist,
wobei das Verarbeitungsmodul (31) ferner zum Erfassen eines Lautstärkewertes jedes Tonsignals des Umgebungstonsignals, zum Festlegen des Tonsignals mit dem größten Lautstärkewert als ein Haupttonsignal und zum Erfassen des Abspiellautstärke-Differenzwertes gemäß dem Lautstärkewert des Haupttonsignals und einem Lautstärkewert des internen Tonsignals konfiguriert ist.

9. Abspiellautstärke-Einstellungsvorrichtung (30) nach Anspruch 8, wobei das Verarbeitungsmodul (31) ein Filterteilmodul und ein Berechnungsteilmodul umfasst, wobei
das Filterteilmodul zum Herausfiltern eines Rauschsignals in dem Umgebungstonsignal, um ein Abspielechosignal zu erhalten, konfiguriert ist und
das Berechnungsteilmodul zum Erfassen des Abspiellautstärke-Differenzwertes gemäß einem Lautstärkewert des Abspielechosignals und einem Lautstärkewert des internen Tonsignals konfiguriert ist.

10. Abspiellautstärke-Einstellungsvorrichtung (30) nach Anspruch 9, wobei das Verarbeitungsmodul (31) ferner ein Bestimmungsteilmodul umfasst, das zum Bestimmen des Rauschsignals in dem Umgebungstonsignal vor dem Herausfiltern des Rauschsignals in dem Umgebungstonsignal konfiguriert ist, und
das Filterteilmodul zum Herausfiltern des Rauschsignals in dem Umgebungstonsignal, das von dem Bestimmungsteilmodul bestimmt wurde, konfiguriert ist.

11. Abspiellautstärke-Einstellungsvorrichtung (30) nach Anspruch 10, wobei das Bestimmungsteilmodul zum Herausfiltern eines Signalteils des Umgebungstonsignals, der sich auf das interne Tonsignal bezieht, gemäß einer Korrelation der Tonsignale, zum Erhalten und Ausgeben des Rauschsignals, wobei die Korrelation der Tonsignale eine Wellenformkorrelation der Tonsignale umfasst, konfiguriert ist.

12. Abspiellautstärke-Einstellungsvorrichtung (30) nach einem der Ansprüche 8 bis 11, wobei,
wenn es nur einen Einstellungsgrenzwert gibt, das Einstellungsmodul (32) für Folgendes konfiguriert ist: Erhöhen der Abspiellautstärke, wenn der Abspiellautstärke-Differenzwert größer als der Einstellungsgrenzwert ist, und Verringern der Abspiellautstärke, wenn der Abspiellautstärke-Differenzwert kleiner als der Einstellungsgrenzwert ist, und
wenn es zwei oder mehr Einstellungsgrenzwerte gibt, das Einstellungsmodul (32) für Folgendes konfiguriert ist: Erhöhen der Abspiellautstärke, wenn der Abspiellautstärke-Differenzwert größer als ein Maximalwert der Einstellungsgrenzwerte ist, Verringern der Abspiellautstärke, wenn der Abspiellautstärke-Differenzwert kleiner als ein Minimalwert der Einstellungsgrenzwerte ist, und kein Einstellen der Abspiellautstärke, wenn der Abspiellautstärke-Differenzwert zwischen dem Minimalwert und dem Maximalwert der Einstellungsgrenzwerte liegt.

13. Abspiellautstärke-Einstellungsvorrichtung (30) nach einem der Ansprüche 8 bis 11, ferner Folgendes umfassend: ein Aktualisierungsmodul, das zum Aktualisieren des Einstellungsgrenzwertes gemäß einem Abspiellautstärke-Differenzwert, wenn die Einstellung durchgeführt wird, und einem Modifikationsgrenzwert, nachdem das Einstellungsmodul (32) die Abspiellautstärke einstellt, konfiguriert ist.

14. Computerlesbares Speichermedium, in dem eine Gruppe von Anweisungen gespeichert ist, die zum Ausführen des Abspiellautstärke-Einstellungsverfahrens nach einem der Ansprüche 1 bis 7 konfiguriert sind.

## Revendications

1. Procédé de réglage d'intensité sonore de lecture, comprenant les étapes ci-dessous consistant à :
acquérir (S101), par le biais d'un terminal, un signal sonore ambiant et un signal sonore interne, et acquérir (S102) une valeur de différence d'intensité sonore de lecture selon le signal sonore ambiant et le signal sonore interne ; et
comparer (S103), par le biais du terminal, la valeur de différence d'intensité sonore de lecture à au moins un seuil de réglage, et régler (S104) l'intensité sonore de lecture selon un résultat de comparaison ;
dans lequel l'étape d'acquisition de la valeur de différence d'intensité sonore de lecture selon le signal sonore ambiant et le signal sonore interne comprend les étapes ci-dessous consistant à : acquérir une valeur d'intensité sonore de chaque signal sonore du signal sonore ambiant, sélectionner le signal sonore présentant la valeur d'intensité sonore la plus élevée en tant qu'un signal sonore principal, et acquérir la valeur de différence d'intensité sonore de lecture selon la valeur d'intensité sonore du signal sonore principal et une valeur d'intensité sonore du signal sonore interne.

2. Procédé de réglage d'intensité sonore de lecture selon la revendication 1, dans lequel l'étape d'acquisition de la valeur de différence d'intensité sonore de lecture selon le signal sonore ambiant et le signal sonore interne comprend les étapes ci-dessous consistant à : filtrer un signal de bruit dans le signal sonore ambiant, en vue d'obtenir un signal d'écho de lecture ; et acquérir la valeur de différence d'intensité sonore de lecture selon une valeur d'intensité sonore du signal d'écho de lecture et une valeur d'intensité sonore du signal sonore interne ; le signal de bruit faisant référence à tous les signaux sonores reçus par un microphone, hormis le signal d'écho de lecture.

3. Procédé de réglage d'intensité sonore de lecture selon la revendication 2, comprenant en outre : avant de filtrer le signal de bruit dans le signal sonore ambiant, une étape consistant à déterminer le signal de bruit dans le signal sonore ambiant,
l'étape de filtrage du signal de bruit dans le signal sonore ambiant consistant à : filtrer le signal de bruit déterminé dans le signal sonore ambiant.

4. Procédé de réglage d'intensité sonore de lecture selon la revendication 3, dans lequel l'étape de détermination du signal de bruit comprend les étapes ci-après consistant à : filtrer une partie de signal du signal sonore ambiant connexe au signal sonore interne selon une corrélation de signaux sonores, et obtenir et fournir en sortie le signal de bruit, la corrélation des signaux sonores comprenant une corrélation de forme d'onde des signaux sonores.

5. Procédé de réglage d'intensité sonore de lecture selon l'une quelconque des revendications 1 à 4, dans lequel :
lorsqu'il n'existe qu'un seul seuil de réglage, l'étape de réglage de l'intensité sonore de lecture selon le résultat de comparaison comprend les étapes ci-après consistant à : augmenter l'intensité sonore de lecture lorsque la valeur de différence d'intensité sonore de lecture est supérieure au seuil de réglage, et diminuer l'intensité sonore de lecture lorsque la valeur de différence d'intensité sonore de lecture est inférieure au seuil de réglage ; et
lorsqu'il existe deux seuils de réglage ou plus, l'étape de réglage de l'intensité sonore de lecture selon le résultat de comparaison comprend les étapes ci-après consistant à : augmenter l'intensité sonore de lecture lorsque la valeur de différence d'intensité sonore de lecture est supérieure à une valeur maximale des seuils de réglage, diminuer l'intensité sonore de lecture lorsque la valeur de différence d'intensité sonore de lecture est inférieure à une valeur minimale des seuils de réglage, et ne pas régler l'intensité sonore de lecture lorsque la valeur de différence d'intensité sonore de lecture se situe entre la valeur minimale et la valeur maximale des seuils de réglage.

6. Procédé de réglage d'intensité sonore de lecture selon l'une quelconque des revendications 1 à 4, comprenant en outre l'étape ci-après consistant à : suite au réglage de l'intensité sonore de lecture, mettre à jour le seuil de réglage selon une valeur de différence d'intensité sonore de lecture lorsque le réglage est mis en oeuvre et selon un seuil de modification.

7. Procédé de réglage d'intensité sonore de lecture selon la revendication 6, dans lequel :
lorsqu'il n'existe qu'un seul seuil de réglage, l'étape de mise à jour du seuil de réglage, selon la valeur de différence d'intensité sonore de lecture lorsque le réglage est mis en oeuvre et selon le seuil de modification, comprend l'étape consistant à : sélectionner une somme de ou une différence entre la valeur de différence d'intensité sonore de lecture lorsque le réglage est mis en oeuvre et le seuil de modification, en tant qu'un nouveau seuil de réglage ; et
lorsqu'il existe deux seuils de réglage ou plus, l'étape de mise à jour du seuil de réglage, selon la valeur de différence d'intensité sonore de lecture lorsque le réglage est mis en oeuvre et selon le seuil de modification, comprend l'étape consistant à : sélectionner une somme de la valeur de différence d'intensité sonore de lecture lorsque le réglage est mis en oeuvre et du seuil de modification, en tant que la valeur maximale d'un nouveau seuil de réglage, et sélectionner une différence entre la valeur de différence d'intensité sonore de lecture lorsque le réglage est mis en oeuvre et le seuil de modification, en tant que la valeur minimale du nouveau seuil de réglage.

8. Dispositif de réglage d'intensité sonore de lecture (30), comprenant un module de traitement (31) et un module de réglage (32), dans lequel :
le module de traitement (31) est configuré de manière à acquérir un signal sonore ambiant et un signal sonore interne, et à acquérir une valeur de différence d'intensité sonore de lecture selon le signal sonore ambiant et le signal sonore interne ; et
le module de réglage (32) est configuré de manière à comparer la valeur de différence d'intensité sonore de lecture à au moins un seuil de réglage, et à régler l'intensité sonore de lecture selon un résultat de comparaison ;
dans lequel le module de traitement (31) est en outre configuré de manière à acquérir une valeur d'intensité sonore de chaque signal sonore du signal sonore ambiant, à sélectionner le signal sonore présentant la valeur d'intensité sonore la plus élevée, en tant qu'un signal sonore principal, et à acquérir la valeur de différence d'intensité sonore de lecture selon la valeur d'intensité sonore du signal sonore principal et une valeur d'intensité sonore du signal sonore interne.

9. Dispositif de réglage d'intensité sonore de lecture (30) selon la revendication 8, dans lequel le module de traitement (31) comprend un sous-module de filtrage et un sous-module de calcul, dans lequel :
le sous-module de filtrage est configuré de manière à filtrer un signal de bruit dans le signal sonore ambiant afin d'obtenir un signal d'écho de lecture ; et
le sous-module de calcul est configuré de manière à acquérir la valeur de différence d'intensité sonore de lecture selon une valeur d'intensité sonore du signal d'écho de lecture et une valeur d'intensité sonore du signal sonore interne.

10. Dispositif de réglage d'intensité sonore de lecture (30) selon la revendication 9, dans lequel le module de traitement (31) comprend en outre un sous-module de détermination configuré de manière à déterminer le signal de bruit dans le signal sonore ambiant avant que le signal de bruit dans le signal sonore ambiant ne soit filtré ; et
le sous-module de filtrage est configuré de manière à filtrer le signal de bruit dans le signal sonore ambiant déterminé par le sous-module de détermination.

11. Dispositif de réglage d'intensité sonore de lecture (30) selon la revendication 10, dans lequel le sous-module de détermination est configuré de manière à filtrer une partie de signal du signal sonore ambiant connexe au signal sonore interne selon une corrélation de signaux sonores, et à obtenir et à fournir en sortie le signal de bruit, la corrélation des signaux sonores comprenant une corrélation de forme d'onde des signaux sonores.

12. Dispositif de réglage d'intensité sonore de lecture (30) selon l'une quelconque des revendications 8 à 11, dans lequel :
lorsqu'il n'existe qu'un seul seuil de réglage, le module de réglage (32) est configuré de manière à : augmenter l'intensité sonore de lecture lorsque la valeur de différence d'intensité sonore de lecture est supérieure au seuil de réglage, et diminuer l'intensité sonore de lecture lorsque la valeur de différence d'intensité sonore de lecture est inférieure au seuil de réglage ; et
lorsqu'il existe deux seuils de réglage ou plus, le module de réglage (32) est configuré de manière à : augmenter l'intensité sonore de lecture lorsque la valeur de différence d'intensité sonore de lecture est supérieure à une valeur maximale des seuils de réglage, diminuer l'intensité sonore de lecture lorsque la valeur de différence d'intensité sonore de lecture est inférieure à une valeur minimale des seuils de réglage, et ne pas régler l'intensité sonore de lecture lorsque la valeur de différence d'intensité sonore de lecture se situe entre la valeur minimale et la valeur maximale des seuils de réglage.

13. Dispositif de réglage d'intensité sonore de lecture (30) selon l'une quelconque des revendications 8 à 11, comprenant en outre : un module de mise à jour configuré de manière à, dès lors que le module de réglage (32) a réglé l'intensité sonore de lecture, mettre à jour le seuil de réglage selon une valeur de différence d'intensité sonore de lecture lorsque le réglage est mis en oeuvre et selon un seuil de modification.

14. Support de stockage lisible par ordinateur dans lequel est stocké un groupe d'instructions configuré de manière à exécuter le procédé de réglage d'intensité sonore de lecture selon l'une quelconque des revendications 1 à 7.
